# EUROPEAN PATENT APPLICATION

(11) **EP 4 686 346 A1**
(43) Date of publication of application: **28.01.2026**
(21) Application number: 25160704.0
(22) Date of filing: 27.02.2025
(51) Int. Cl.: H10F 19/90, H10F 77/20

(54) **PHOTOVOLTAIC MODULE AND MANUFACTURING METHOD THEREOF**

(30) Priority: 24.07.2024 CN 202411001195
(71) Applicant: Tongwei Solar (Chengdu) Co., Ltd., Chengdu, Sichuan 610299 (CN)
(72) Inventor: Liu, Luolin, Chengdu, 610299 (CN); Long, Mingyang, Chengdu, 610299 (CN); Xia, Zhengyue, Chengdu, 610299 (CN); Xing, Guoqiang, Chengdu, 610299 (CN)
(74) Representative: Michalski Hüttermann & Partner Patentanwälte mbB

(57) **Abstract**

The present invention relates to a photovoltaic module and a manufacturing method thereof. The photovoltaic module includes a plurality of solar cells and a plurality of PV ribbons configured to connect the plurality of solar cells; each solar cell includes a cell body, a gridline, a solder pad, an insulating layer, and a conductive adhesive, the gridline is provided on a surface of the cell body, the solder pad and the conductive adhesive are respectively provided on the gridline and are electrically connected to the gridline, the insulating layer covers the gridline and exposes the solder pad and the conductive adhesive, the solder pad and the conductive adhesive are respectively connected to the PV ribbon. By providing the conductive adhesive on the gridline, when the PV ribbon is soldered, the PV ribbon is pre-fixed through the conductive adhesive.

## Description

### TECHNICAL FIELD

The present application relates to the field of photovoltaic technology, particularly to a photovoltaic module and a manufacturing method thereof.

### BACKGROUND

In the manufacturing process of a photovoltaic module, multiple solar cells are connected in series through PV ribbons. Gridlines are distributed on a surface of the solar cell, and are configured to collect currents. Multiple solder pads are distributed on the gridlines, a solder pad has a width greater than that of a gridline, and the solder pad is configured to weld a PV ribbon, to implement interconnection between the solar cells. Each PV ribbon needs to simultaneously connect positive gridlines and negative gridlines of two adjacent solar cells respectively, in order to form a conductive loop.

In the stringing process, insulation paste is printed on the solar cell, and the insulation paste covers the gridline between the solder pads, to prevent short circuit caused after the PV ribbons are connected. After the insulation paste is cured, the PV ribbon is provided on the solder pad, and then the PV ribbon is fixed onto the solder pad through soldering. Before the soldering, the PV ribbon needs to be pre-fixed onto the solder pad to prevent the PV ribbon from being offset during the soldering.

At present, the soldering process of the PV ribbon includes infrared soldering, laser soldering, and the like. In the infrared soldering process, heating is performed by a thermal radiation. Accordingly, a press mesh may be provided on the PV ribbon to pre-fix the PV ribbon. In the laser soldering process, since the laser beam needs to irradiate on the solder pad, if the press mesh is utilized to fix the PV ribbon, the press mesh may block the laser beam and affect the soldering quality. Therefore, in the conventional laser soldering process, the PV ribbon is bonded and fixed by an adhesive tape after the insulation paste is cured, or the PV ribbon is inserted into an adhesive film for fixation.

However, the fixing mode using the adhesive tape has a dissatisfied fixing effect, and the tape stickiness may decrease in a high-temperature environment during the soldering, which tends to cause an offset of the PV ribbon. In addition, the mode of inserting the PV ribbon into the film has a greater production difficulty, which may also affect the laser soldering quality.

### SUMMARY

In view of this, in order to address the above technical problem of offset of the PV ribbon occurring during the soldering, it is necessary to provide a photovoltaic module and a manufacturing method thereof.

In the first aspect of the present invention, a photovoltaic module is provided, including a plurality of solar cells and a plurality of PV ribbons configured to connect the plurality of solar cells. Each solar cell includes a cell body, a gridline, a solder pad, an insulating layer, and a conductive adhesive, the gridline is provided on a surface of the cell body, the solder pad and the conductive adhesive are respectively provided on the gridline and are electrically connected to the gridline, the insulating layer covers the gridline and exposes the solder pad and the conductive adhesive, the solder pad and the conductive adhesive are respectively connected to the PV ribbon.

In an embodiment, the gridline includes a plurality of busbars and fingers, each busbar is connected to a plurality of fingers, the insulating layer covers the busbar, the solder pad and the conductive adhesive are provided on the busbar.

In an embodiment, a peripheral edge of the conductive adhesive is surrounded by the insulating layer.

In an embodiment, a shape of the conductive adhesive is one or more of a circle, an ellipse, or a polygon.

In an embodiment, an area of the conductive adhesive is in a range of 0.01mm² to 3.14mm².

In an embodiment, a thickness of the conductive adhesive is in a range of 5µm to 60µm.

In an embodiment, a plurality of solder pads and a plurality of conductive adhesives on the same gridline are arranged alternately.

In an embodiment, the number of conductive adhesives located on the same gridline is in a range of 3 to 20.

In an embodiment, a plurality of conductive adhesives located on the same gridline are uniformly arranged.

In an embodiment, a distance between adjacent conductive adhesives located on the same gridline is in a range of 2mm to 20mm.

In an embodiment, the conductive adhesive includes conductive particles and an adhesive body for bonding the conductive particles.

In an embodiment, a material of the conductive particles includes one or more of silver, copper, nickel, gold, aluminum, iron, or carbon.

In an embodiment, the adhesive body includes an organic polymer.

In an embodiment, a volume ratio of the conductive particles to the adhesive body is equal to (0.5~5) : 1.

In the second aspect of the present invention, a method for manufacturing a photovoltaic module is provided, including: providing a plurality of cell bodies, arranging a gridline on a surface of each cell body, and arranging a solder pad on the gridline; providing an insulating layer and a conductive adhesive on the gridline, in which the conductive adhesive is arranged on the gridline and is electrically connected to the gridline, the insulating layer covers the gridline and exposes the solder pad and the conductive adhesive; and providing the PV ribbon on the solder pad and the conductive adhesive, to allow the conductive adhesive to adhere to the PV ribbon, to pre-connect adjacent cell bodies through the PV ribbon; soldering the PV ribbon to the solder pad.

In an embodiment, the PV ribbon is soldered to the solder pad through a laser soldering process.

In an embodiment, the insulating layer is provided on the gridline through screen printing.

In an embodiment, a screen plate used in the screen printing includes a plate body and a shielding member, the plate body is provided with a plurality of hollow-out printing regions, each of which is provided with the shielding member, each hollow-out printing region is configured to form the insulating layer through printing, the shielding member is configured to form a printing blank region in the insulating layer, the printing blank region is configured to arrange the conductive adhesive.

In an embodiment, the conductive adhesive is provided on the gridline through a mode of adhesive dispensing.

Compared to the conventional technology, the photovoltaic module and the manufacturing method thereof have the following advantages.

In the aforementioned photovoltaic module and manufacturing method thereof, the insulating layer is provided on the gridline, and the insulating layer covers the gridline along the gridline, which avoids a short circuit caused by soldering of the PV ribbon. In addition, the conductive adhesive is provided on the gridline, and the conductive adhesive is electrically connected to the gridline. When the PV ribbon is soldered, the PV ribbon is pre-fixed through the conductive adhesive, which can prevent displacement and pseudo soldering of the PV ribbon. Further, the PV ribbon is connected to the solder pad. In such a manner, a string soldering tension can be effectively improved, and the reliability of the module can be improved.

In addition, the solder pad is generally formed by sintering a silver paste, the cost of which is relatively high. The conductive adhesive is arranged to be connected to the PV ribbon, part of the current collected by the gridline can also be introduced into the PV ribbon through the conductive adhesive. In such a manner, a current path can be shortened in the case of no additional solder pad and lower cost, and accordingly the power loss and heat accumulation of the current can be reduced, and the conductive efficiency of the PV ribbon can be improved.

### BRIEF DESCRIPTION OF THE DRAWINGS

FIG. 1 is a schematic structural diagram of a photovoltaic module according to an embodiment.
FIG. 2 is a cross-sectional view of the photovoltaic module shown in FIG. 1.
FIG. 3 is a flow chart of a method for manufacturing a photovoltaic module according to an embodiment.
FIG. 4 (a) is a schematic structural diagram of a cell body on a surface of which are provided gridlines and solder pads according to an embodiment.
FIG. 4 (b) is a schematic diagram of providing an insulating layer on a gridline according to an embodiment.
FIG. 4 (c) is a schematic diagram of providing a conductive adhesive on a gridline according to an embodiment.
FIG. 4 (d) is a schematic diagram of providing a PV ribbon on a pad pint and a conductive adhesive according to an embodiment.
FIG. 4 (e) is a schematic diagram of soldering a PV ribbon to a solder pad according to an embodiment.
FIG. 5 is a schematic structural diagram of a screen plate used in a method for manufacturing a photovoltaic module according to an embodiment.

### Reference signs:

10, photovoltaic module; 100, solar cell; 110, cell body; 111, gridline; 1112, busbar; 1114, finger; 112, solder pad; 113, insulating layer; 114, conductive adhesive; 200, PV ribbon; 20, screen plate; 21, plate body; 212, hollow-out printing region; 214, interval region; 22, shielding member.

### DETAILED DESCRIPTION OF THE EMBODIMENTS

In order to make the purpose, technical solution and advantages of the present invention more clearly understood, the present invention is further described in detail below in conjunction with the accompanying drawings and embodiments. Many specific details are described below to facilitate full understanding of the present invention. However, the present invention may be implemented in many different manners from those described herein. A person skilled in the art can make similar improvements without departing from the conception of the present invention. Accordingly, the present invention is not limited to the specific embodiments disclosed below.

Unless otherwise defined, all technical and scientific terms used herein are of the same meaning as is commonly understood by those skilled in the art of the present invention. The terms used in the specification of the present invention are merely intended to describe specific embodiments, and are not intended to limit the present invention. The term "and/or" used herein includes any and all combinations of one or more associated listed items.

In the description of the present invention, it should be appreciated that, orientations or positional relationships indicated by terms such as "center", "longitudinal", "horizontal", "length", "width", "thickness", "upper", "lower", "front", "back", "left", "right", "vertical", "horizontal", "top", "bottom", "inside", "outside", "clockwise", "anticlockwise", "axial", "radial", and "circumferential" and the like, are based on the orientations or positional relationships in the accompanying drawings, and these terms are merely intended to facilitate the description of the present invention and simplification of the description, rather than indicating or implying that the a device or element definitely has a specific orientation, or is constructed and operates according to the specific orientation, and thus these terms are not understood as restrictions on the present invention.

In addition, terms such as "first" or "second" and the like are merely used for the purpose of description, and are not understood as indicating or implying relative importance or implicitly indicating the number of the specific technical features. Accordingly, a feature defined with "first" or "second" may explicitly or implicitly include at least one of the features. In the description of the present invention, the term "multiple" means at least two, for example, two, three, and so on, unless otherwise specifically limited.

In the present invention, unless otherwise specified and limited, the terms "installation", "coupling", "connection", "fixing" and the like, shall be understood broadly. For example, the connection may be a fixed connection, or a detachable connection, or may be integrated into one; the connection may be a mechanical connection, or an electrical connection; the connection may be a direct connection, or an indirect connection through an intermediate medium, or an internal communication of two components, or an interaction relationship between two components, unless otherwise specifically limited. A person of ordinary skill in the art may understand specific meanings of the above terms in the present invention according to specific conditions.

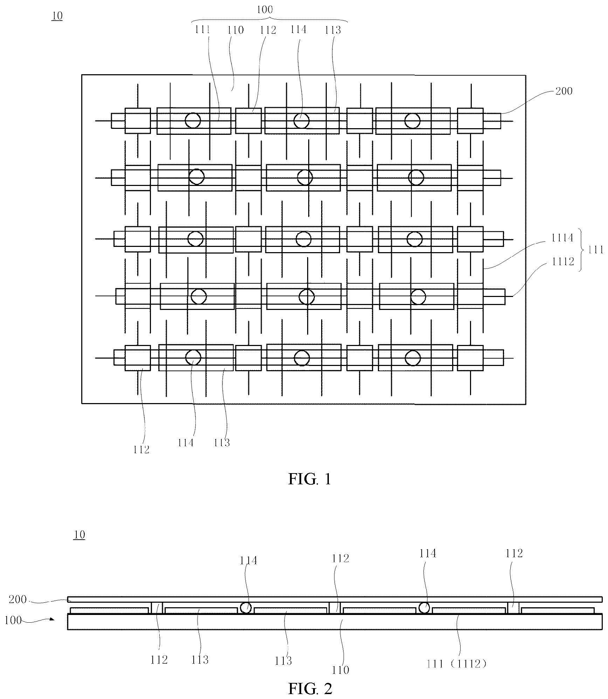

Referring to FIG. 1 and FIG. 2, a photovoltaic module 10 in an embodiment may include a plurality of solar cells 100 and a plurality of PV ribbons 200 configured to connect the plurality of solar cells 100.

The solar cell 100 includes a cell body 110, a gridline 111, a solder pad 112, an insulating layer 113, and a conductive adhesive 114. The gridline 111 is provided on a surface of the cell body 110. The solder pad 112 and the conductive adhesive 114 are respectively provided on the gridline 111 and are electrically connected to the gridline 111. The insulating layer 113 covers the gridline 111, and the insulating layer 113 exposes the solder pad 112 and the conductive adhesive 114. The solder pad 112 and the conductive adhesive 114 are respectively connected to the PV ribbon 200.

In the above-mentioned photovoltaic module 10, the insulating layer 113 is provided on the gridline 111, and the insulating layer 113 covers the gridline 111 along the gridline 111, which avoids a short circuit caused by soldering of the PV ribbon 200. In addition, the conductive adhesive 114 is provided on the gridline 111, and the conductive adhesive 114 is electrically connected to the gridline 111. When the PV ribbon 200 is soldered, the PV ribbon 200 is pre-fixed through the conductive adhesive 114, which can prevent displacement and pseudo soldering of the PV ribbon 200. Further, the PV ribbon 200 is connected to the solder pad 112. In such a manner, a string soldering tension can be effectively improved, and the reliability of the module can be improved.

In addition, the solder pad 112 is generally formed by sintering a silver paste, the cost of which is relatively high. The conductive adhesive 114 is arranged to be connected to the PV ribbon 200, a part of current collected by the gridline 111 can also be introduced into the PV ribbon 200 through the conductive adhesive 114. In such a manner, a current path can be shortened in the case of no additional solder pad 112 and lower cost, accordingly the power loss and heat accumulation of the current can be reduced, and the conductive efficiency of the PV ribbon 200 can be improved.

The cell body 110 may be but is not limited to a Back Contact (BC) cell with all gridlines located on the back of the cell, a Tunnel Oxide Passivating Contact (TOPCon) cell, a Passivated Emitter and Rear Cell (PERC), a heterojunction (HJT) cell, etc.

In some examples, the gridline 111 includes a busbar 1112 and a finger 1114. There exists a plurality of busbars 1112, each of which is connected to a plurality of fingers 1114. For example, the busbar 1112 extends in a first direction, the plurality of busbars 1112 are arranged in parallel, and the finger 1114 extends in a second direction. The first direction is at an angle to the second direction, and the angle may be but is not limited to a right angle.

In the example, the solder pad 112 and the conductive adhesive 114 are provided on the busbar 1112. The conductive adhesive 114 is connected to the busbar 1112 but is not connected to the finger 1114, in order to avoid causing a short circuit. The insulating layer 113 extends in the first direction and covers the busbar 1112, in order to avoid a short circuit caused by soldering the PV ribbon 200.

It should be appreciated that the gridlines include positive gridlines and negative gridlines. The positive gridline includes a positive busbar and a positive finger. The negative gridline includes a negative busbar and a negative finger. The PV ribbon 200 respectively connects the positive gridlines and the negative gridlines of two adjacent solar cells 100 to form a conductive loop.

The positive gridline and the negative gridline may be respectively located on both sides of the cell body 110, or may be located on the same side surface of the cell body 110. When all the gridlines 111 are located on the same side surface of the cell body 110, a side of cell body 110 with the gridlines 111 serves as a backlight side, and a side of cell body 110 without the gridline 111 serves as a light-receiving side, in order to prevent the gridline 111 from blocking light, thereby improving the cell efficiency.

In some examples, all gridlines 111 are located on the same side surface of the cell body 110, and the positive gridline and negative gridline are arranged in an interdigital distribution. More specifically, in the second direction, a plurality of positive busbars and a plurality of negative busbars are arranged alternately. In the first direction, a plurality of positive fingers connected to a positive busbar and a plurality of negative fingers connected to an adjacent negative busbar are arranged alternately.

In addition, for a solar cell 100 without a busbar 1112, the PV ribbon 200 can also be initially fixed by using the conductive adhesive 114, and then be fixed at the solder pad 112 through soldering. Compared to the lamination soldering, this manner can greatly improve the reliability of the photovoltaic module 10.

In some examples, the conductive adhesive 114 includes conductive particles and an adhesive body for bonding the conductive particles. A material of the conductive particles may be, for example, one or more of silver, copper, nickel, gold, aluminum, iron, or carbon, etc. The adhesive body may be, for example, an organic polymer. The organic polymer may be but is not limited to one or more of a polypropylene resin, an epoxy resin, a polyurethane, a phenolic resin, a urea resin, a vinyl alcohol resin, a butyl rubber, a silicone rubber, or the like. In some examples, a volume ratio of the conductive particles to the adhesive body is equal to (0.5~5) : 1, specifically, 0.5 : 1, 0.8 : 1, 1 : 1, 2 : 1, 3 : 1, 4 : 1, 5 : 1, or the like.

In some examples, a peripheral edge of the conductive adhesive 114 is surrounded by the insulating layer 113, and accordingly, the effect of the insulating layer 113 in preventing short circuit can be improved. In the example, a width of the conductive adhesive 114 is less than a width of the insulating layer 113. For example, a ratio of the width of the conductive adhesive 114 to the width of the insulating layer 113 is equal to (0.1~0.8) : 1, specifically, 0.1 : 1, 0.2 : 1, 0.3 : 1, 0.4 : 1, 0.5 : 1, 0.6 : 1, and 0.8 : 1, or the like.

In some examples, a thickness of the conductive adhesive 114 is not less than a thickness of the insulating layer 113, so that the conductive adhesive 114 can better pre-fix the PV ribbon 200. Further, the thickness of the conductive adhesive 114 is greater than the thickness of the insulating layer 113.

In some examples, the thickness of the conductive adhesive 114 is in a range of 5mm to 60mm, for example, 10 mm, 20 mm, 25 mm, 30 mm, 35 mm, 40mm50mm, and 60 mm, etc.

An area of the conductive adhesive 114 may be set with reference to an area of the solder pad 112, as long as a certain degree of fixation of the PV ribbon 200 can be ensured. For example, a ratio of the area of the conductive adhesive 114 to the area of the solder pad 112 is equal to (0.2~0.8) : 1, specifically, 0.2 : 1, 0.3 : 1, 0.4 : 1, 0.5 : 1, 0.6 : 1, 0.7 : 1, and 08 : 1, etc.

In some examples, the area of the conductive adhesive 114 is in a range of 0.01mm² to 3.14mm², specifically, 0.01mm², 0.03mm², 0.20mm², 0.50mm², 0.79mm², 1.77mm², 3.14mm², etc.

Optionally, a shape of the conductive adhesive 114 may be but is not limited to one or more of a circle, an ellipse, or a polygon.

The polygon is, for example, a triangle, a quadrilateral, a pentagon, or a hexagon, etc. The polygon may be an equilateral polygon, such as an equilateral triangle, a square, a regular pentagon, or a regular hexagon, etc., or may be an inequilateral polygon.

In some examples, the conductive adhesive 114 is circular, and a diameter of the conductive adhesive 114 is in a range of 0.1mm to 2mm, for example, 0.1 mm, 0.2 mm, 0.5 mm, 0.7mm, 0.9mm, 1.1mm, 1.5 mm, 2 mm, etc.

In some examples, the conductive adhesive 114 is rectangular, and has a length of 0.1mm to 2mm and a width of 0.1mm to 2mm.

In some examples, the number of conductive adhesives 114 located on the same gridline 111 is in a range of 3 to 20, for example, 3, 6, 8, 10, 12, 14, 16, 18, and 20, etc.

In some examples, a plurality of conductive adhesives 114 located on the same gridline 111 are uniformly distributed.

In some examples, a distance between adjacent conductive adhesives 114 on the same gridline 111 is in a range of 2mm to 20mm, specifically, 2 mm, 4 mm, 6 mm, 8 mm, 10 mm, 16 mm, 18mm, 20 mm, and the like.

In some examples, a plurality of solder pads 112 and a plurality of conductive adhesives 114 are arranged alternately on the same gridline 111.

Further, the present invention further provides a method for manufacturing the photovoltaic module 10 in any one of the aforementioned examples.

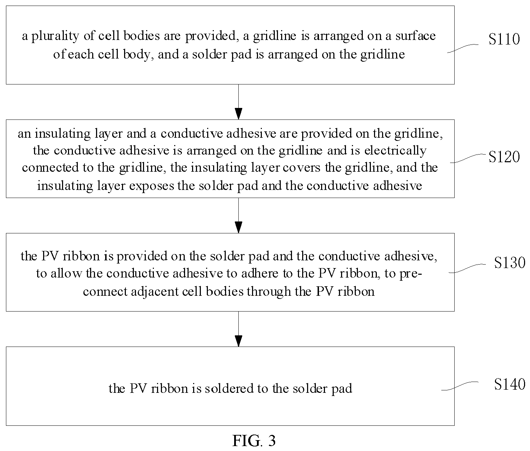

As shown in FIG. 3, in an embodiment, a method for manufacturing a photovoltaic module 10 includes the following steps.

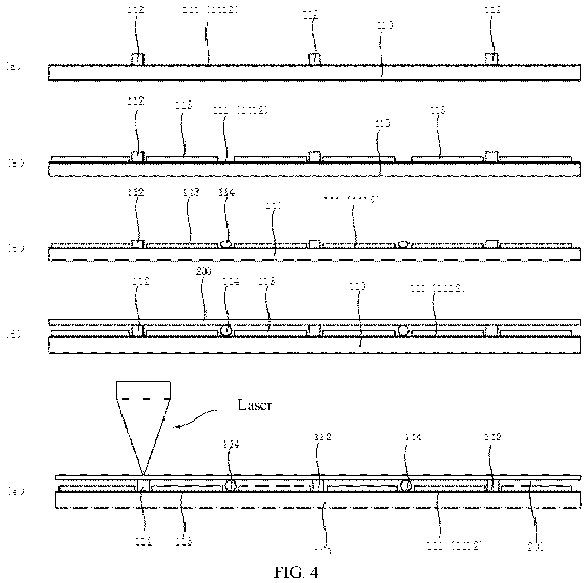

Step S110: as shown in FIG. 4 (a), a plurality of cell bodies 110 are provided, gridlines 111 are arranged on a surface of each cell body 110, and a solder pad 112 is arranged on the gridline 111.

Step S120: As shown in FIGS. 4(b) and 4(c) in FIG. 4, an insulating layer 113 and a conductive adhesive 114 are provided on the gridline 111, the conductive adhesive 114 is arranged on the gridline 111 and is electrically connected to the gridline 111, the insulating layer 113 covers the gridline 111, and the insulating layer 113 exposes the solder pad 112 and the conductive adhesive 114.

Step S130: as shown in FIG. 4 (d), the PV ribbon 200 is provided on the solder pad 112 and the conductive adhesive 114, to allow the conductive adhesive 114 to adhere to the PV ribbon 200, to pre-connect adjacent cell bodies 110 through the PV ribbon 200.

Step S140: as shown in FIG. 4 (e), the PV ribbon 200 is soldered to the solder pad 112.

In the above method for manufacturing the photovoltaic module 10, the insulating layer 113 is provided on the gridline 111, and the insulating layer 113 covers the gridline 111 along the gridline 111, thereby avoiding a short circuit caused by soldering the PV ribbon 200. In addition, the conductive adhesive 114 is provided on the gridline 111, and the conductive adhesive 114 is electrically connected to the gridline 111. When the PV ribbon 200 is soldered, the PV ribbon 200 is pre-fixed by means of the conductive adhesive 114, which can prevent displacement and pseudo soldering of the PV ribbon 200 in a subsequent soldering process, and then the pre-fixed PV ribbon 200 is soldered to the solder pad 112. In such a manner, the string soldering tension can be effectively improved, and the reliability of the module can be improved.

In addition, the solder pad 112 is generally formed by sintering a silver paste, the cost of which is relatively high. The conductive adhesive 114 is arranged to be connected to the PV ribbon 200, a partial current collected by the gridline 111 can also be introduced into the PV ribbon 200 through the conductive adhesive 114. In such a manner, a current path can be shortened in the case of no additional solder pad 112 and lower cost, accordingly the power loss and heat accumulation of the current can be reduced, and the conductive efficiency of the PV ribbon 200 can be improved.

Optionally, in the step S120, a mode in which the insulating layer 113 and the conductive adhesive 114 are provided on the gridline 111 may be but is not limited to screen printing, scraping, spraying, roll coating, brush coating, adhesive dispensing, or the like.

In some examples, the insulating layer 113 is provided on the gridline 111 through a mode of screen printing, and the conductive adhesive 114 is provided on the gridline 111 through a mode of adhesive dispensing.

More specifically, the step of providing the insulating layer 113 and the conductive adhesive 114 on the gridline 111 may include:
a screen plate 20 is provided on the cell body 110, and screen printing is performed to form the insulating layer 113; and
adhesive dispensing is performed on the cell body 110 to form the conductive adhesive 114.

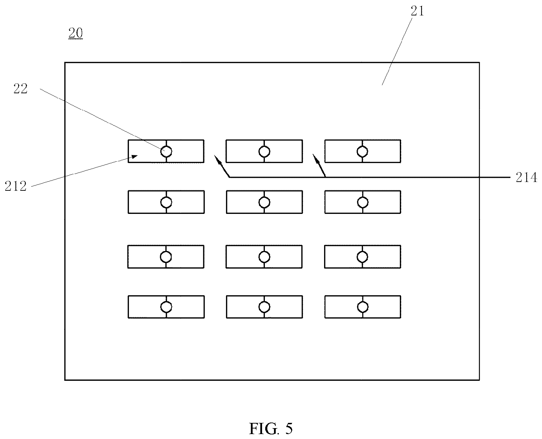

As shown in FIG. 5, the screen plate 20 used in the screen printing includes a plate body 21 and a shielding member 22. The plate body 21 is provided with a plurality of hollow-out printing regions 212, each of which is provided with the shielding member 22.

The hollow-out printing region 212 is configured to form the insulating layer 113 through printing. Compared to a conventional screen plate, each hollow-out printing region of the screen plate 20 is further provided with a shielding member 22, and the shielding member 22 is configured to form a printing blank region in the insulating layer 113. The printing blank region is configured to arrange the conductive adhesive 114, to facilitate the conductive contact between the conductive adhesive 114 the gridline 111.

In some examples, the hollow-out printing region 212 is a strip-shaped hole extending in the first direction. In the first direction, a plurality of hollow-out printing regions 212 are arranged at intervals, and an interval region 214 between adjacent hollow-out printing regions 212 is a region in which the solder pad 112 is located. In the second direction perpendicular to the first direction, the plurality of hollow-out printing regions 212 are arranged at intervals. In such a manner, the plurality of hollow-out printing regions 212 on the plate body 21 are arranged in an array.

In some examples, a ratio of a width of the shielding member 22 to a width of the hollow-out printing region 212 is equal to (0.2~0.8) : 1, specifically for example, 0.2 : 1, 0.3 : 1, 0.4 : 1, 0.5 : 1, 0.6 : 1, 0.7 : 1, and 0.8 : 1, etc.

An area of the shielding member 22 is in a range of 0.01mm² to 3.14mm², specifically for example, 0.01mm², 0.03mm², 0.20mm², 0.50mm², 0.79mm², 1.77mm², and 3.14mm², etc.

Optionally, a shape of the shielding member 22 may be but is not limited to one or more of a circle, an ellipse, or a polygon.

The polygon is, for example, a triangle, a quadrilateral, a pentagon, or a hexagon, etc. The polygon may be an equilateral polygon, such as an equilateral triangle, a square, a regular pentagon, or a regular hexagon, etc., or may be an inequilateral polygon.

In some examples, the shielding member 22 is circular, and a diameter of the shielding member 22 is in a range of 0.1mm to 1.5mm, specifically for example, 0.1 mm, 0.2 mm, 0.5 mm, 0.7mm, 0.9mm, 1.1mm, 1.3mm, and 1.5 mm, etc.

In some examples, the shielding member 22 is rectangular, and has a length of 0.1mm to 2mm and a width of 0.1mm to 2mm.

In some examples, in the step S140, the PV ribbon 200 is soldered to the solder pad 112 through a laser soldering process. In other examples, the method is not limited to the laser soldering process, and may be, for example, an infrared soldering process.

The method for manufacturing the photovoltaic module 10 will be further detailed through a specific embodiment as follows.

A method for manufacturing a photovoltaic module 10 in a specific embodiment includes the following steps.

Step 1: as shown in FIG. 4 (a), a plurality of cell bodies 110 are provided, and gridlines 111 of each cell body 110 are provided on a back surface of the cell body 110; a gridline 111 includes a busbar 1112 and a finger 1114, and a solder pad 112 is provided on the busbar 1112.

Step 2: as shown in FIG. 4 (b), screen printing is performed on the cell body 110 to form an insulating layer 113; the insulating layer 113 covers the busbar 1112 along the busbar 1112, and the insulating layer 113 exposes the solder pad 112 and a printing blank region of the busbar 1112.

Step 3: as shown in FIG. 4 (c), a conductive adhesive 114 is formed by performing adhesive dispensing in the printing blank region; the conductive adhesive 114 is circular with a diameter of 0.3 mm; the solder pad 112 and the conductive adhesive 114 located on the same gridline 111 are arranged alternately.

Step 4: as shown in FIG. 4 (d), a PV ribbon 200 is provided on the solder pad 112 and the conductive adhesive 114, to allow the conductive adhesive 114 to adhere to the PV ribbon 200, to pre-connect adjacent cell bodies 110 through the PV ribbon 200.

Step 5: as shown in FIG. 4 (e), laser soldering is performed between the PV ribbon 200 and the solder pad 112.

In the aforementioned embodiment, no problems such as offset of the PV ribbon, pseudo soldering or short circuit and so on of the gridlines occur during the stringing process, and a PV ribbon tension reaches 3N or more.

The technical features in the above embodiments may be combined arbitrarily. In order to make the description concise, all possible combinations of the technical features in the above embodiments are not described. However, as long as there is no contradiction in the combinations of these technical features, these combinations should be considered to be within the scope of the present application.

The above-described embodiments only express several implementation modes of the present invention, and the descriptions are relatively specific and detailed, but should not be construed as limiting the scope of the present invention. It should be noted that, those of ordinary skill in the art can make several transformations and improvements without departing from the concept of the present invention, and these all fall within the protection scope of the present invention. Therefore, the protection scope of the present invention should be subject to the appended claims.

## Claims

1. A photovoltaic module (10), comprising a plurality of solar cells (100) and a plurality of PV ribbons (200) configured to connect the plurality of solar cells (100);
wherein each solar cell (100) comprises a cell body (110), a gridline (111), a solder pad (112), an insulating layer (113), and a conductive adhesive (114), the gridline (111) is provided on a surface of the cell body (110), the solder pad (112) and the conductive adhesive (114) are respectively provided on the gridline (111) and are electrically connected to the gridline (111), the insulating layer (113) covers the gridline (111) and exposes the solder pad (112) and the conductive adhesive (114), and the solder pad (112) and the conductive adhesive (114) are respectively connected to the PV ribbon (200).

2. The photovoltaic module (10) according to claim 1, wherein the gridline (111) comprises a plurality of busbars (1112) and fingers (1114), each busbar is connected to a plurality of fingers (1114), the insulating layer (113) covers the busbar (1112), and the solder pad (112) and the conductive adhesive (114) are provided on the busbar (1112).

3. The photovoltaic module (10) according to claim 1, wherein a peripheral edge of the conductive adhesive (114) is surrounded by the insulating layer (113).

4. The photovoltaic module (10) according to claim 1, wherein a shape of the conductive adhesive (114) is one or more of a circle, an ellipse, or a polygon.

5. The photovoltaic module (10) according to claim 1, wherein the photovoltaic module (10) has one or more of the following characteristics:
an area of the conductive adhesive (114) is in a range of 0.01mm² to 3.14mm²; or
a thickness of the conductive adhesive (114) is in a range of 5µm to 60µm.

6. The photovoltaic module (10) according to claim 1, wherein a plurality of solder pads (112) and a plurality of conductive adhesives (114) on the same gridline (111) are arranged alternately.

7. The photovoltaic module (10) according to claim 1, wherein the photovoltaic module (10) has one or more of the following characteristics:
the number of conductive adhesives (114) located on the same gridline (111) is in a range of 3 to 20;
a plurality of conductive adhesives (114) located on the same gridline (111) are uniformly arranged; or
a distance between adjacent conductive adhesives (114) located on the same gridline (111) is in a range of 2mm to 20mm.

8. The photovoltaic module (10) according to any one of claims 1 to 7, wherein the conductive adhesive (114) comprises conductive particles and an adhesive body for bonding the conductive particles.

9. The photovoltaic module (10) according to claim 8, wherein the photovoltaic module (10) has one or more of the following characteristics:
a material of the conductive particles comprises one or more of silver, copper, nickel, gold, aluminum, iron, or carbon;
the adhesive body comprises an organic polymer; or
a volume ratio of the conductive particles to the adhesive body is equal to (0.5~5) : 1.

10. A method for manufacturing a photovoltaic module (10), comprising:
providing a plurality of cell bodies (110), wherein a gridline (111) is arranged on a surface of each cell body (110), and a solder pad (112) is arranged on the gridline (111);
providing an insulating layer (113) and a conductive adhesive (114) on the gridline (111), wherein the conductive adhesive (114) is arranged on the gridline (111) and is electrically connected to the gridline (111), and the insulating layer (113) covers the gridline (111) and exposes the solder pad (112) and the conductive adhesive (114);
providing the PV ribbon (200) on the solder pad (112) and the conductive adhesive (114), to allow the conductive adhesive (114) to adhere to the PV ribbon (200), to pre-connect adjacent cell bodies (110) through the PV ribbon (200); and
soldering the PV ribbon (200) to the solder pad (112).

11. The method according to claim 10, wherein the PV ribbon (200) is soldered to the solder pad (112) through a laser soldering process.

12. The method according to claim 10, wherein the insulating layer (113) is provided on the gridline (111) through screen printing.

13. The method according to claim 12, wherein a screen plate (20) used in the screen printing comprises a plate body (21) and a shielding member (22), the plate body (21) is provided with a plurality of hollow-out printing regions (212), each of which is provided with the shielding member (22), each hollow-out printing region (212) is configured to form the insulating layer (113) through printing, the shielding member (22) is configured to form a printing blank region in the insulating layer (113), and the printing blank region is configured to arrange the conductive adhesive (114).

14. The method according to any one of claims 10 to 13, wherein the conductive adhesive (114) is provided on the gridline (111) through adhesive dispensing.
